# EUROPEAN PATENT APPLICATION

(11) **EP 4 679 941 A1**
(43) Date of publication of application: **14.01.2026**
(21) Application number: 24769794.9
(22) Date of filing: 05.03.2024
(51) Int. Cl.: H05K 1/02, H05K 7/20, H01L 23/36

(54) **THROUGH-FLOW HEAT DISSIPATION STRUCTURE, PRINTED CIRCUIT BOARD, AND MANUFACTURING METHOD FOR PRINTED CIRCUIT BOARD**

(30) Priority: 13.03.2023 CN 202310280720
(71) Applicant: ZTE CORPORATION, Shenzhen, Guangdong 518057 (CN)
(72) Inventor: DONG, Tonghe, Shenzhen, Guangdong 518057 (CN); LU, Xian, Shenzhen, Guangdong 518057 (CN); BAI, Ruolan, Shenzhen, Guangdong 518057 (CN)
(74) Representative: Ziebig Hengelhaupt Intellectual Property Attorneys Patentanwaltskanzlei PartGmbB
(86) International application number: PCT/CN2024/080063
(87) International publication number: WO 2024/188100

(57) **Abstract**

The present application relates to the fields of surface-mount devices, electrical components and the like, and discloses a through-flow heat dissipation structure, a printed circuit board, and a manufacturing method for a printed circuit board. The through-flow heat dissipation structure is applied to a circuit board, and comprises: a conductive member and a heat dissipation member; the conductive member comprises a first side surface and a second side surface disposed opposite to each other along a first direction; the first side surface is configured to be connected to a conductive layer of the circuit board; and the heat dissipation member is arranged on the second side surface, and projects from the second side surface. The printed circuit board comprises the through-flow heat dissipation structure. The manufacturing method for the printed circuit board is used for manufacturing the printed circuit board.

## Description

### CROSS-REFERENCE TO RELATED APPLICATIONS

The present invention claims the priority to the Chinese patent application filed with the Chinese Patent Office on March 13, 2023, with the application number of 202310280720.7, and the title of "THROUGH-FLOW HEAT DISSIPATION STRUCTURE, PRINTED CIRCUIT BOARD AND MANUFACTURING METHOD FOR PRINTED CIRCUIT BOARD", the entire contents of which are incorporated herein by reference.

### TECHNICAL FIELD

The present application belongs to the fields of surface-mount devices, electrical components and the like, and relates to a through-flow heat dissipation structure, a printed circuit board, and a manufacturing method for a printed circuit board.

### BACKGROUND

The operation of various chips on a Printed Circuit Board (PCB) relies on the functions of different power networks. As competition in the electronics product market becomes increasingly fierce, the requirements for cost control of PCBs are gradually rising. The number of PCB layers is being compressed, resulting in a more constrained space for power network.

Due to manufacturing processes, the surface layer of a PCB has a relatively greater thickness compared to most of the inner-layer copper foils. Moreover, since the impedance of the surface layer is more difficult to control, when designing power supplies, greater attention is often paid to the utilization of the surface layer and how to reduce the power loss during current transmission in power networks.

Some PCBs in related technologies only consider how to reduce power loss during current transmission in power networks during the design process. However, the heat generated by the inner-layer copper cladding of the PCB cannot be dissipated effectively, thus failing to achieve optimal heat dissipation performance.

### SUMMARY

The objective of the embodiments in the present application is to provide a through-flow heat dissipation structure, a printed circuit board, and a manufacturing method for a printed circuit board, which can address the problems in related technologies where the PCB fails to balance both current flowing and heat dissipation.

To solve the aforementioned technical problems, the present application is implemented as follows.

An embodiment of the present application provides a through-flow heat dissipation structure applicable to a circuit board. The through-flow heat dissipation structure includes: a conductive member and a heat dissipation member; the conductive member includes a first side surface and a second side surface disposed opposite to each other along a first direction, the first side surface is configured to be connected to a conductive layer of the circuit board, and the heat dissipation member is arranged on the second side surface, and projects from the second side surface.

An embodiment of the present application further provides a printed circuit board, including: a circuit board surface layer, a copper foil layer with circuits arranged thereon, a solder mask layer disposed on the copper foil layer, and a plurality of the through-flow heat dissipation structures; the copper foil layer is the conductive layer, the copper foil layer is arranged on the circuit board surface layer, the solder mask layer is arranged on the copper foil layer, and the solder mask layer is provided with a plurality of window areas, and the copper foil layer forms a plurality of pad areas at positions respectively opposite to the plurality of window areas; and the respective conductive members of the plurality of through-flow heat dissipation structures are respectively connected to the plurality of pad areas.

An embodiment of the present application further provides a manufacturing method for a printed circuit board, used for manufacturing the printed circuit board mentioned above, and the manufacturing method includes: fabricating a printed circuit board including a copper foil layer with surface-layer windows; and disposing a conductive member of a through-flow heat dissipation structure on a pad area of the copper foil layer corresponding to the window position, so that the conductive member of the through-flow heat dissipation structure is connected to the pad area.

### BRIEF DESCRIPTION OF DRAWINGS

FIG. 1 is a partial schematic diagram showing the first type of the through-flow heat dissipation structure and the printed circuit board as disclosed in an embodiment of the present application;
FIG. 2 is a partial schematic diagram showing the second type of the through-flow heat dissipation structure and the printed circuit board as disclosed in an embodiment of the present application;
FIG. 3 is a front view of the first type of the through-flow heat dissipation structure as disclosed in an embodiment of the present application;
FIG. 4 is a top view of the first type of the through-flow heat dissipation structure as disclosed in an embodiment of the present application;
FIG. 5 is a front view of the second type of the through-flow heat dissipation structure as disclosed in an embodiment of the present application;
FIG. 6 is a top view of the second type of the through-flow heat dissipation structure as disclosed in an embodiment of the present application;
FIG. 7 is a front view of the third type of the through-flow heat dissipation structure as disclosed in an embodiment of the present application;
FIG. 8 is a top view of the third type of the through-flow heat dissipation structure as disclosed in an embodiment of the present application;
FIG. 9 is a front view of the fourth type of the through-flow heat dissipation structure as disclosed in an embodiment of the present application;
FIG. 10 is a top view of the fourth type of the through-flow heat dissipation structure as disclosed in an embodiment of the present application;
FIG. 11 is a front view of the fifth type of the through-flow heat dissipation structure as disclosed in an embodiment of the present application;
FIG. 12 is a top view of the fifth type of the through-flow heat dissipation structure as disclosed in an embodiment of the present application;
FIG. 13 is a front view of the circuit board surface layer, the copper foil layer, and the solder mask layer as disclosed in an embodiment of the present application;
FIG. 14 is a top view of the circuit board surface layer, the copper foil layer, and the solder mask layer as disclosed in an embodiment of the present application;
FIG. 15 is a structural schematic diagram showing the application of the through-flow heat dissipation structure in a narrow and long power network as disclosed in an embodiment of the present application;
FIG. 16 is a structural schematic diagram showing the application of the through-flow heat dissipation structure in a wide and large power network as disclosed in an embodiment of the present application;
FIG. 17 is a simulation schematic diagram illustrating the heat dissipation effect when the PCB is equipped with the through-flow heat dissipation structure as disclosed in an embodiment of the present application;
FIG. 18 is a schematic diagram of the simulation result when the PCB is not equipped with the through-flow heat dissipation structure as disclosed in an embodiment of the present application; and
FIG. 19 is a schematic diagram of the simulation result when the PCB is equipped with the through-flow heat dissipation structure as disclosed in an embodiment of the present application.

### Description of reference signs:

100-through-flow heat dissipation structure; 110-conductive member; 111-first side surface; 112-second side surface; 120-heat dissipation member; 121-elongated structure; 1211-pointed structure; 122-sheet-shaped structure; 200-circuit board surface layer; 300-copper foil layer; 310-pad area; 400-solder mask layer; 410-window area.

### DETAILED DESCRIPTION

Hereinafter, the technical solutions in the embodiments of the present application will be clearly and completely described with reference to the accompanying drawings in the embodiments of the present application, and it is obvious that the described embodiments are part of the embodiments of the present application, but not all the embodiments. Based on the embodiments in the present application, all other embodiments obtained by those skilled in the art without creative work fall within the scope of protection of the present application.

The terms "first", "second", and the like in the specification and claims of the present application are used to distinguish similar objects, and are not used to describe a particular order or sequence. It should be understood that such data used may be interchangeable where appropriate so that embodiments of the present application can be implemented in an order other than those illustrated or described herein, and that objects distinguished by "first", "second", etc. are generally one class, and the number of objects is not limited, for example, the first object may be one or a plurality of objects. In addition, "and/or" in the specification and claims indicates at least one of the connected objects, and the character "/" generally indicates that the related objects before and after are in an "or" relationship.

Hereinafter, embodiments of the present application will be described in detail with reference to specific embodiments and application scenarios thereof with reference to the drawings.

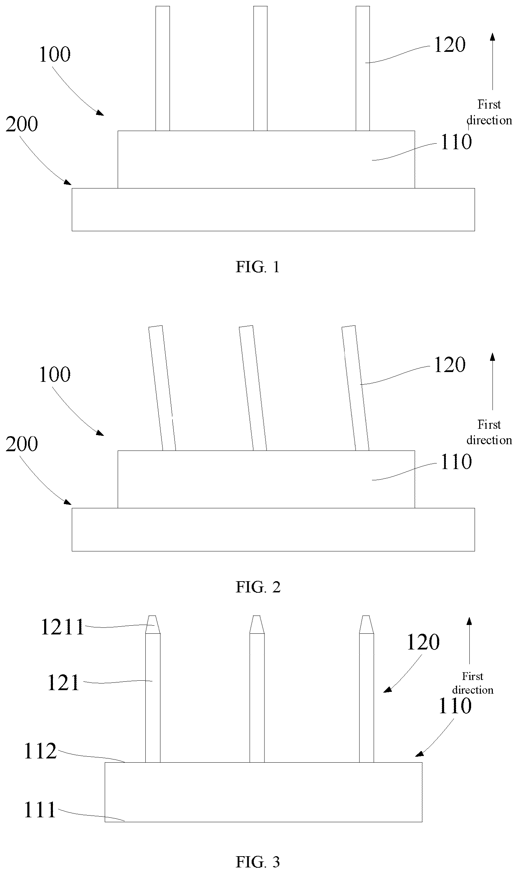

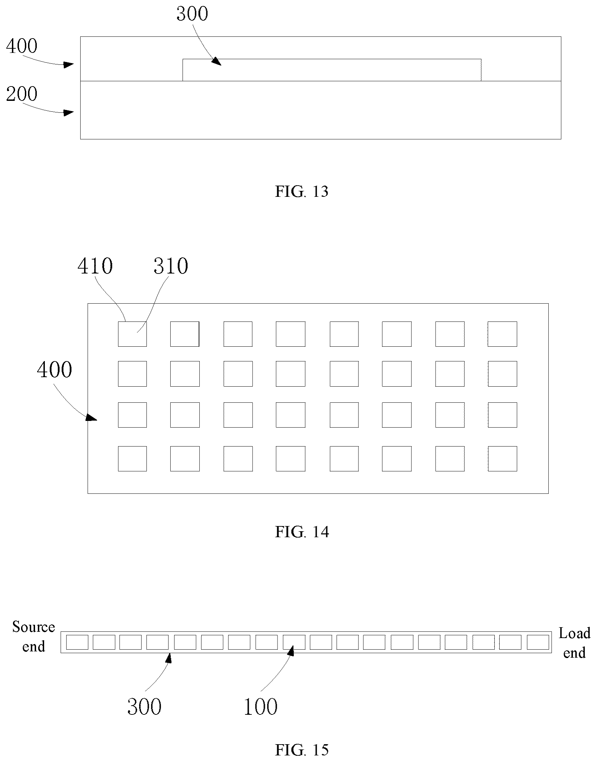

With reference to FIGS. 1 to 19, an embodiment of the present application discloses a through-flow heat dissipation structure 100, which can be applied to the circuit board for current flowing and heat dissipation. Of course, the through-flow heat dissipation structure 100 can also be applied to other electrical components. The embodiment of the present application does not specifically limit the application scenarios of the through-flow heat dissipation structure 100. The disclosed through-flow heat dissipation structure 100 includes a conductive member 110 and a heat dissipation member 120, wherein the conductive member 110 can have both electrical conductivity and thermal conductivity functions, while the heat dissipation member 120 can have thermal conductivity and heat dissipation functions.

In some embodiments, the conductive member 110 includes a first side surface 111 and a second side surface 112, with the first side surface 111 and the second side surface 112 being arranged opposite to each other along a first direction. For instance, the conductive member 110 can be in the form of a plate-shaped structure, a sheet-shaped structure, or a block-shaped structure, etc. The first direction can be the thickness direction of the plate-shaped, sheet-shaped, or block-shaped structure. Under actual operating conditions, the first direction can be the direction perpendicular to the surface of the circuit board.

The first side surface 111 is used for being connected to the conductive layer of the circuit board. Specifically, the first side surface 111 covers the surface of at least part of the area of the conductive layer, and the connection between the first side surface 111 and the conductive layer can relatively fix the conductive member 110 to the conductive layer, thereby preventing the through-flow heat dissipation structure 100 from detaching from the circuit board.

Additionally, the heat dissipation member 120 is positioned on the second side surface 112, enabling heat transferred from the conductive layer to the conductive member 110 to be passed through the second side surface 112 to the heat dissipation member 120 and then dissipated outward by the heat dissipation member 120. This serves to cool the circuit board, preventing excessive temperatures that could affect its service life or cause damage.

To further enhance the heat dissipation effect, the heat dissipation member 120 projects from the second side surface 112. This configuration increases the surface area of the heat dissipation member 120 in contact with the surrounding air and enlarges its windward area, thereby improving the convective heat transfer efficiency between the heat dissipation member 120 and the surrounding air. Consequently, the heat dissipation performance of the heat dissipation member 120 is enhanced, providing better cooling for the circuit board. Moreover, when the contact area between the conductive member 110 and the conductive layer remains constant, this configuration also increases the convective heat dissipation efficiency of the entire through-flow heat dissipation structure 100, further improving its overall heat dissipation performance.

In the embodiments of the present application, the conductive member 110 is connected to the conductive layer of the circuit board, and the heat dissipation member 120 is in contact with the conductive member 110. On one hand, the connection between the conductive member 110 and the conductive layer can increase the overall conductive cross-section of the circuit board. Compared to the method where the circuit board conducts electricity solely through the conductive layer, this approach can reduce the equivalent resistance in the area where the conductive member 110 is installed on the circuit board, thereby effectively lowering the impedance when current passes through. Consequently, it can reduce current losses, decrease the voltage drop in the power network, and minimize heat generation during current flowing, thus preventing excessive temperatures on the circuit board. On the other hand, it allows heat generated during the operation of the circuit board to be transferred through the conductive layer to the conductive member 110, then to the heat dissipation member 120 through the conductive member 110, and finally dissipated outward through the heat dissipation member 120, thus improving the heat dissipation effect on the circuit board. Therefore, by installing the through-flow heat dissipation structure 100 on the conductive layer of the circuit board, the embodiments of the present application can reduce losses during current transmission, minimize heat generation, and enhance heat dissipation, ensuring that the temperature of the circuit board does not become excessively high.

In some embodiments, the extension direction of the heat dissipation member 120 forms a preset angle with a first direction, with the range of this preset angle being 0° to 80°, including, for example, 0°, 10°, 20°, 30°, 40°, 45°, 50°, 60°, 70°, 80°, etc. Of course, other angles are also possible as long as they ensure that the heat dissipation member 120 projects to a preset height above the second side surface 112. The specific form is not limited.

As shown in FIG. 1, when the preset angle is 0°, it indicates that the extension direction of the heat dissipation member 120 is perpendicular to the second side surface 112. In this case, the effective height of the heat dissipation member 120 (i.e., the distance perpendicular to the surface of the circuit board) is greater. Under the same surrounding conditions, this approach enables greater contact probability between the heat dissipation member 120 and the surrounding air, thereby improving the convective heat transfer efficiency between the heat dissipation member 120 and the air, and enhancing the heat dissipation efficiency.

As shown in FIG. 2, when the preset angle is between 0° and 80°, such as 30°, 45°, 60°, etc., it indicates that the heat dissipation member 120 is inclined. In this case, although the effective height of the heat dissipation member 120 decreases somewhat, the wind resistance generated at the heat dissipation member 120 also decreases accordingly, reducing the impact of airflow on the heat dissipation member 120. Thus, while ensuring good heat dissipation performance, it can effectively alleviate the problem of deformation or even breakage of the heat dissipation member 120 due to airflow impact, ensuring the service life of the heat dissipation member 120.

It should be noted that when the heat dissipation member 120 is inclined, it can extend in a direction that follows the airflow, meaning that the angle between the extension direction of the heat dissipation member 120 and the airflow direction is less than 90°, thereby reducing the impact of airflow on the heat dissipation member 120 and lowering wind noise. Of course, the heat dissipation member 120 can also extend in a direction opposite to the airflow, meaning that the angle between the extension direction of the heat dissipation member 120 and the airflow direction is greater than 90°. This arrangement can also ensure good heat dissipation performance.

Referring to FIGS. 3 to 8, in some embodiments, the heat dissipation member 120 can be an elongated structure 121. This structure allows the heat dissipation member 120 to have a sufficiently large contact area with the surrounding air while also reducing wind resistance and wind noise. Additionally, the length and cross-sectional area of the elongated structure 121 are not limited.

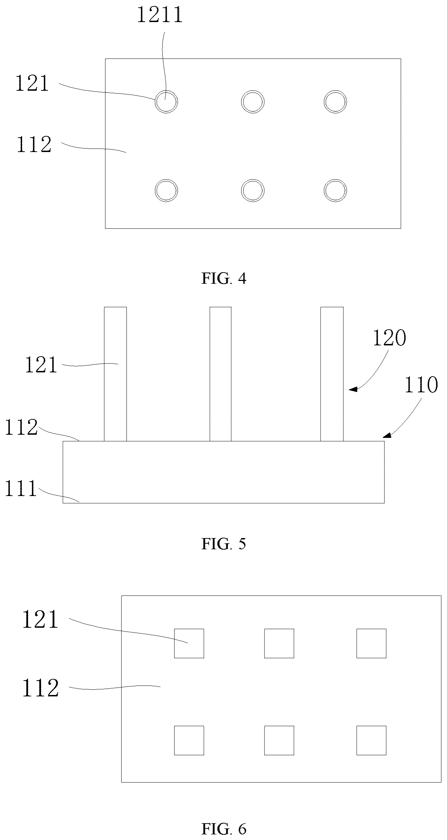

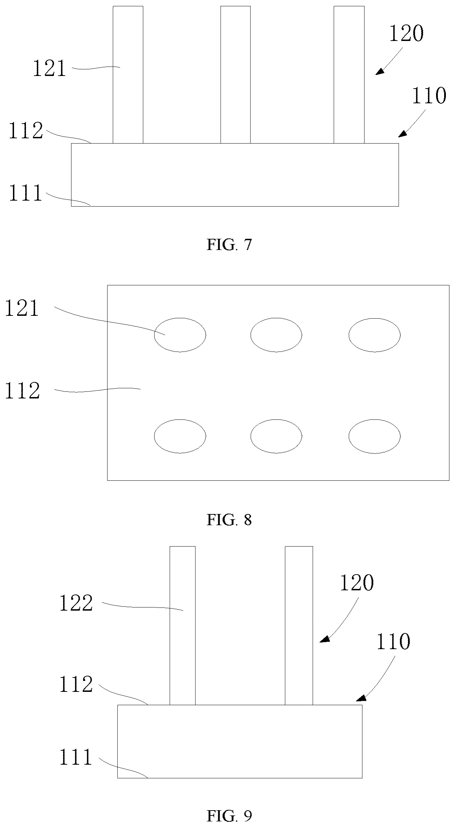

The shape of the cross-section of the elongated structure 121 perpendicular to the first direction can include a circle, a polygon, or an ellipse. For example, the elongated structure 121 can be a cylindrical structure, as shown in FIGS. 3 and 4, a prismatic structure, as shown in FIGS. 5 and 6, or an elliptical cylindrical structure, as shown in FIGS. 7 and 8, and the like. Of course, the shape of the elongated structure 121 is not limited to the above and can be any other shape as long as it projects from the second side surface 112.

In the embodiments of the present application, the elongated structure 121 can have a first end and a second end along its length (i.e., extension direction). The first end of the elongated structure 121 is connected to the second side surface 112 to ensure the stability and firmness of the elongated structure 121. Additionally, the second end of the elongated structure 121 is provided with a pointed structure 1211, as shown in FIGS. 3 and 4. The cross-section of the pointed structure 1211 gradually decreases along the first direction. The configuration of the pointed structure 1211 can, to a certain extent, reduce the impact of airflow on the second end of the elongated structure 121, thereby effectively alleviating the problem of bending deformation or even breakage of the elongated structure 121 under airflow impact. It can also help reduce wind resistance and wind noise. For example, the second end of the elongated structure 121 can be designed as a frustum surface, conical surface, etc. Of course, other shapes are also possible, and no specific limitation is imposed here.

In some embodiments, the elongated structure 121 can be designed as a heat dissipation pin structure. Due to the relatively smooth surface of the heat dissipation pin, it can improve heat dissipation performance while reducing wind resistance and wind noise.

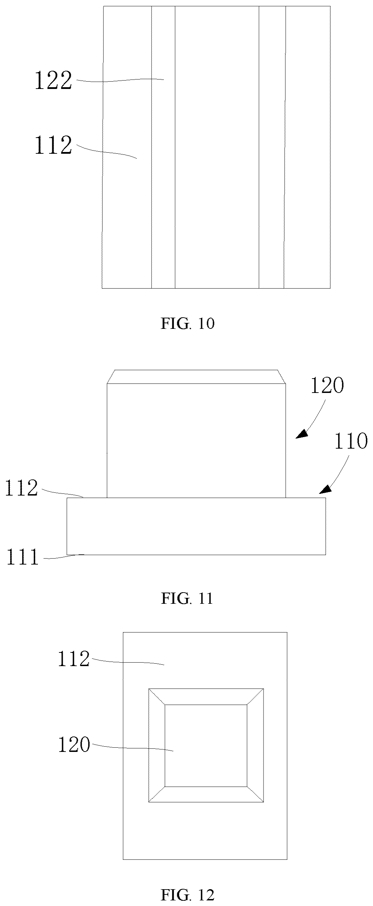

In other embodiments, as shown in FIGS. 9 and 10, the heat dissipation member 120 can be a sheet-shaped structure 122. This structure can increase the contact area between the heat dissipation member 120 and the surrounding air, thereby improving the heat dissipation effect. It can also increase the contact area between the heat dissipation member 120 and the conductive member 110, thereby improving the firmness of the connection.

Under actual operating conditions, the surface of the sheet-shaped structure 122 can be parallel, perpendicular, or at any other angle to the airflow direction. When the surface of the sheet-shaped structure 122 is parallel to the airflow direction, wind resistance and wind noise can be minimized, and the impact of airflow on the sheet-shaped structure 122 can be reduced, alleviating the problem of bending deformation or even breakage of the sheet-shaped structure 122 due to airflow impact.

When the sheet-shaped structure 122 is perpendicular to the airflow direction, the effective contact area is maximized, but so is the area subject to airflow impact. In this case, although the heat dissipation effect is optimal, the impact of the airflow is also greatest, making the sheet-shaped structure 122 susceptible to damage.

When the angle between the surface of the sheet-shaped structure 122 and the airflow direction is between 0° and 90°, such as 30°, 45°, 60°, etc., this approach can ensure a sufficiently large effective heat dissipation area while reducing the impact of airflow, ensuring the normal use of the sheet-shaped structure 122. It should be noted that the angle between the surface of the sheet-shaped structure 122 and the airflow direction can be set according to actual operating conditions, and no specific limitation is imposed on the specific angle.

The sheet-shaped structure 122 can have a flat, curved, or wavy surface.

When the sheet-shaped structure 122 has a flat surface, the contact area between the airflow and the flat surface is relatively small when the airflow comes into contact and flows along it. However, the flat surface also offers relatively little resistance to the airflow, allowing the sheet-shaped structure 122 to maintain relatively low wind resistance and wind noise while possessing certain heat dissipation capabilities, thereby improving the service life of the sheet-shaped structure 122.

When the sheet-shaped structure 122 has a curved surface, the contact area between the airflow and the curved surface increases somewhat when the airflow comes into contact and flows along it. At the same time, the resistance offered by the curved surface to the airflow also increases somewhat. This approach also allows the sheet-shaped structure 122 to maintain relatively low wind resistance and wind noise while possessing certain heat dissipation capabilities, thereby improving the service life of the sheet-shaped structure 122.

When the sheet-shaped structure 122 has a wavy surface, the contact area between the airflow and the wavy surface is relatively large when the airflow comes into contact and flows along it. At the same time, the resistance offered by the wavy surface to the airflow is also relatively large. This approach ensures that the sheet-shaped structure 122 has good heat dissipation performance while also taking into account wind resistance and wind noise.

In other embodiments, the heat dissipation member 120 can also be a hollow structure, specifically a hollow elongated structure 121, such as a hollow cylindrical structure, a hollow prismatic structure, or a hollow elliptical cylindrical structure, etc. It can also be a hollow sheet-shaped structure 122, such as a hollow rectangular sheet structure, etc.

By adopting a hollow design, the overall surface area of the heat dissipation member 120 can be significantly increased, allowing the airflow to fully contact the heat dissipation member 120 when passing through it, thereby achieving good heat dissipation performance.

In the embodiments of the present application, the through-flow heat dissipation structure 100 can include a plurality of heat dissipation members 120 arranged on the second side surface 112. This arrangement can increase the contact area with the ambient air through the plurality of heat dissipation members 120, facilitating improved heat dissipation performance. Of course, the specific number and arrangement of the heat dissipation members 120 can be selected according to actual operating conditions as long as they meet the requirements. No specific limitation is imposed on the specific method.

For example, when the heat dissipation member 120 is an elongated structure 121, it can be arranged in a 2*3, 3*3, 3*4 pattern, etc. Of course, other arrangements are also possible. When the heat dissipation member 120 is a sheet-shaped structure 122, a plurality of sheet-shaped structures 122 can be arranged perpendicular to the airflow direction.

In some embodiments, the conductive member 110 can be a metal patch attached to the conductive layer. The metal patch ensures a sufficiently large contact area between the conductive member 110 and the conductive layer, improving heat dissipation performance while also ensuring good electrical conductivity between the two.

The connection between the conductive member 110 and the conductive layer can include welding. Specifically, the first side surface 111 is attached to the surface of the conductive layer, and the edges or other areas of the conductive member 110 are fixed to the surface of the conductive layer through welding. This approach ensures the firmness of the connection between the conductive member 110 and the conductive layer while also ensuring electrical conductivity between them, facilitating the formation of an integrated conductor and helping to reduce current flowing losses.

In other embodiments, the connection between the conductive member 110 and the conductive layer can also include conductive adhesive bonding. Specifically, the conductive adhesive can be applied to at least one of the first side surface 111 and the surface of the conductive layer, and a certain pressing force is applied to the conductive member 110 to ensure that the first side surface 111 and the surface of the conductive layer are firmly bonded together through the conductive adhesive. This approach achieves a fixed connection between the conductive member 110 and the conductive layer through the conductive adhesive while also ensuring electrical conductivity between them, facilitating the formation of an integrated conductor and helping to reduce current flowing losses.

It should be noted that conductive adhesive is an adhesive that can conduct electricity, specifically by adding conductive fillers to the adhesive. For example, conductive silver adhesive, copper powder conductive adhesive, nickel-carbon conductive adhesive, silver-copper conductive adhesive, etc., can be used. Of course, other substances that simultaneously possess adhesive and conductive properties can also be used, and no specific limitation is imposed in the embodiments of the present application.

In addition to the welding and conductive adhesive bonding methods mentioned above, other electrical connection methods can also be used, and no specific limitation is imposed here.

In the embodiments of the present application, the conductive member 110 and the heat dissipation member 120 can be of an integrally formed structure, meaning that the entire through-flow heat dissipation structure 100 is an integrated structure. This approach facilitates manufacturing while also ensuring the overall strength of the through-flow heat dissipation structure 100.

Of course, the conductive member 110 and the heat dissipation member 120 can also be fixedly connected, such as through welding, to ensure firmness while also providing electrical conductivity and heat transfer effects.

Furthermore, the entire through-flow heat dissipation structure 100 can be made of pure metal or metal alloy to ensure good current conduction and heat transfer effects while also possessing high strength. Of course, other materials can also be used, and no specific limitation is imposed here. For example, the material of the through-flow heat dissipation structure 100 can be pure metal conductive materials such as copper, iron, or aluminum, or metal alloy materials such as copper, iron, or aluminum alloys.

Referring to FIGS. 1, 2, 13 to 16, based on the above through-flow heat dissipation structure 100, the embodiments of the present application also disclose a printed circuit board. The disclosed printed circuit board includes a circuit board surface layer 200, a copper foil layer 300 with circuits arranged thereon, a solder mask layer 400 disposed on the copper foil layer 300, and a plurality of the through-flow heat dissipation structures 100. The copper foil layer 300 serves as the above conductive layer and is disposed on the circuit board surface layer 200. The solder mask layer 400 is disposed on the copper foil layer 300 and has a plurality of window areas 410. The copper foil layer 300 forms a plurality of pad areas 310 at positions corresponding to the plurality of window areas 410. The conductive members 110 of the plurality of through-flow heat dissipation structures 100 are respectively connected to the plurality of pad areas 310.

Based on the above arrangement, connecting the through-flow heat dissipation structures 100 to the pads of the copper foil layer 300 can effectively improve the overall current-flowing capacity of the printed circuit board while also dissipating heat generated by the printed circuit board to achieve a heat dissipation effect. The solder mask layer 400 covers the surface of the copper foil layer 300, protecting the copper foil layer 300 and providing clearance for the connection of the through-flow heat dissipation structures 100 to the copper foil layer 300 through the window areas 410.

For example, the solder mask layer 400 can be an ink layer, but other layer structures can also be used, and no specific limitation is imposed here. Additionally, the solder mask layer 400 can be covered on the surface of the copper foil layer 300 through screen printing.

Based on the above printed circuit board, the embodiments of the present application also disclose a manufacturing method for a printed circuit board to manufacture the above printed circuit board. The disclosed manufacturing method includes:
a printed circuit board including a copper foil layer 300 with surface-layer windows is fabricated; and
a conductive member 110 of a through-flow heat dissipation structure 100 is disposed on a pad area 310 of the copper foil layer 300 corresponding to the window position, so that the conductive member 110 of the through-flow heat dissipation structure 100 is connected to the pad area 310.

Based on the above steps, a printed circuit board connected with a through-flow heat dissipation structure 100 can be manufactured. The configuration of the through-flow heat dissipation structure 100 can improve the overall current-flowing capacity and heat dissipation capacity of the printed circuit board, thereby enhancing the performance of the entire printed circuit board.

The manufacturing method for a printed circuit board in the embodiments of the present application specifically includes:
1. A printed circuit board welded with through-flow heat dissipation structures 100 is designed and manufactured.

Step 1, Simulation: the power network of the printed circuit board is simulated according to the system design requirements. The simulation result shows that the voltage drop or temperature rise requirements of the system design cannot be met.

Step 2, Gerber data preparation: any electronic design automation (EDA) software can be used for design, including but not limited to Cadence, etc.

Network layout diagram creation: the various electronic components are arranged according to the design schematic diagram.

Network routing: the electronic components are connected by using wires or by laying out the copper foil layer 300 to form the entire network structure diagram.

On the copper foil layer 300 of a power network that requires optimization, packages of the through-flow heat dissipation structures 100 are added. The number of these through-flow heat dissipation structures 100 to be added can be determined based on the size of the copper foil layer 300, the direction of current flow, or the locations of hot spots.

Step 3, Gerber file output: Gerber files in a universal format with file extensions recognizable by printed circuit board (PCB) manufacturers are output.

Step 4, Structural installation: the through-flow heat dissipation structures 100 are installed onto the printed circuit board using a reflow soldering process in the processing workshop.

In the embodiments of the present application, by installing the through-flow heat dissipation structure 100 on the printed circuit board, the overall resistance of the power pathway of the printed circuit board can be reduced, achieving higher heat dissipation efficiency and capacity while effectively solving the problems of power voltage drop and heat dissipation.

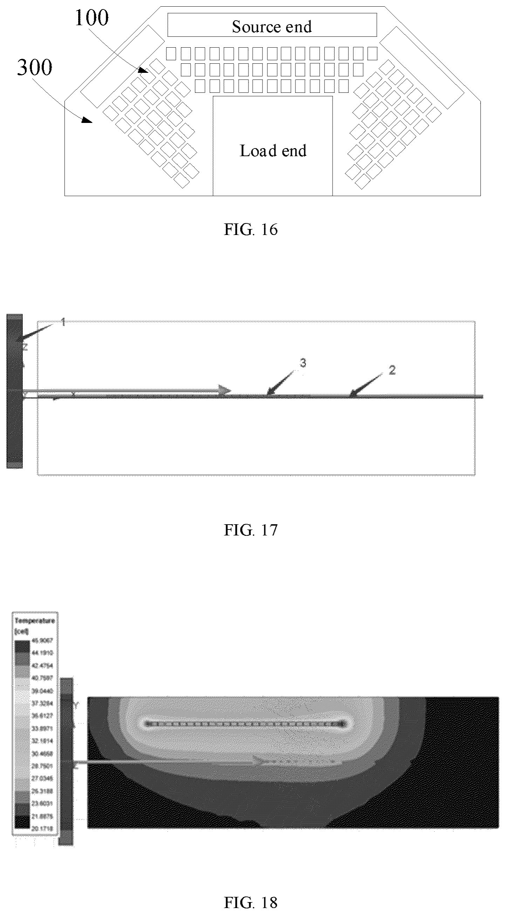

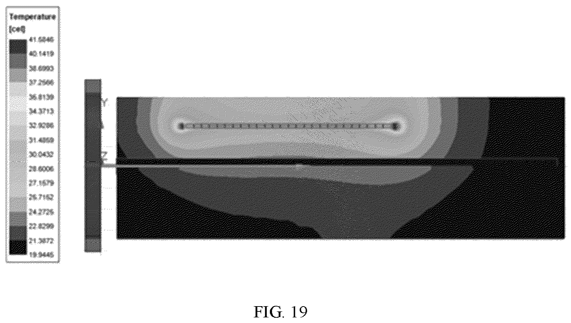

Referring to the simulation conditions shown in FIG. 17, wherein, 1 represents a fan model, 2 represents a multilayer printed circuit board, and 3 represents the installation position of the through-flow heat dissipation structure 100. Referring to FIGS. 18 and 19, when only a through-flow structure is employed under a current of 40A, the simulated voltage drop is 363.6mv, and the hotspot temperature is 45.9°C. When the through-flow heat dissipation structure 100 is employed under the same current of 40A, the simulated voltage drop is 358.9mv, and the hotspot temperature is 41.6°C. It can be seen that when the through-flow heat dissipation structure 100 in the embodiments of the present application is used, the voltage drop decreases, and the hotspot temperature also decreases, thereby reducing power losses and ensuring good heat dissipation performance.

The embodiments of the present application have been described above with reference to the accompanying drawings, but the present application is not limited to the above-described specific embodiments, which are merely schematic and not restrictive, and those skilled in the art can make many forms under the inspiration of the present application without departing from the purpose of the present application and the scope of protection of the claims, all of which fall within the protection of the present application.

## Claims

1. A through-flow heat dissipation structure, applied to a circuit board, wherein the through-flow heat dissipation structure (100) comprises: a conductive member (110) and a heat dissipation member (120);
the conductive member (110) comprises a first side surface (111) and a second side surface (112) disposed opposite to each other along a first direction, the first side surface (111) is configured to be connected to a conductive layer of the circuit board, and the heat dissipation member (120) is arranged on the second side surface (112), and projects from the second side surface (112).

2. The through-flow heat dissipation structure according to claim 1, wherein a preset angle is formed between an extending direction of the heat dissipation member (120) and the first direction, and the preset angle ranges from 0° to 80°.

3. The through-flow heat dissipation structure according to claim 2, wherein the heat dissipation member (120) is an elongated structure (121).

4. The through-flow heat dissipation structure according to claim 3, wherein the shape of a cross-section of the elongated structure (121) perpendicular to the first direction comprises a circle, a polygon, or an ellipse.

5. The through-flow heat dissipation structure according to claim 3, wherein a first end of the elongated structure (121) is connected to the second side surface (112), and a second end of the elongated structure (121) is provided with a pointed structure (1211); and
the cross-sectional area of the pointed structure (1211) gradually decreases along the first direction.

6. The through-flow heat dissipation structure according to claim 2, wherein the heat dissipation member (120) is a sheet-shaped structure (122).

7. The through-flow heat dissipation structure according to claim 6, wherein the sheet-shaped structure (122) has a flat surface, a curved surface, or a wavy surface.

8. The through-flow heat dissipation structure according to claim 2, wherein the heat dissipation member (120) is a hollow-out structure.

9. The through-flow heat dissipation structure according to any one of claims 1 to 8, wherein the through-flow heat dissipation structure (100) comprises a plurality of the heat dissipation members (120), and the plurality of heat dissipation members (120) are arranged on the second side surface (112).

10. The through-flow heat dissipation structure according to claim 1, wherein the conductive member (110) is a metal patch, and the metal patch is attached to the conductive layer.

11. The through-flow heat dissipation structure according to claim 1 or 10, wherein the connection method between the conductive member (110) and the conductive layer comprises welding or bonding with conductive adhesive.

12. The through-flow heat dissipation structure according to claim 1, wherein the conductive member (110) and the heat dissipation member (120) are of an integrally formed structure.

13. The through-flow heat dissipation structure according to claim 12, wherein the material of the through-flow heat dissipation structure (100) comprises pure metal or metal alloy.

14. A printed circuit board, comprising: a circuit board surface layer (200), a copper foil layer (300) with circuits arranged thereon, a solder mask layer (400) disposed on the copper foil layer (300), and a plurality of the through-flow heat dissipation structures (100) according to any one of claims 1 to 13;
the copper foil layer (300) is the conductive layer, the copper foil layer (300) is arranged on the circuit board surface layer (200), the solder mask layer (400) is arranged on the copper foil layer (300), and the solder mask layer (400) is provided with a plurality of window areas (410), and the copper foil layer (300) forms a plurality of pad areas (310) at positions respectively opposite to the plurality of window areas (410); and
the conductive members (110) of the plurality of through-flow heat dissipation structures (100) are respectively connected to the plurality of pad areas (310).

15. A manufacturing method for a printed circuit board, used for manufacturing the printed circuit board according to claim 14, wherein the manufacturing method comprises:
fabricating a printed circuit board comprising a copper foil layer (300) with surface-layer windows; and
disposing a conductive member (110) of a through-flow heat dissipation structure (100) on a pad area (310) of the copper foil layer (300) corresponding to the window position, so that the conductive member (110) of the through-flow heat dissipation structure (100) is connected to the pad area (310).
